Europäisches Patentamt

European Patent Office

Office européen des brevets

(19)

(11) Veröffentlichungsnummer: **0 329 993**
**A2**

# EUROPÄISCHE PATENTANMELDUNG

(21) Anmeldenummer: 89101833.5

(22) Anmeldetag: 02.02.89

(51) Int. Cl.⁴: **H01L 29/743 , //H01L27/06**

(30) Priorität: 25.02.88 DE 3806000

(43) Veröffentlichungstag der Anmeldung:
30.08.89 Patentblatt 89/35

(84) Benannte Vertragsstaaten:
CH DE FR GB IT LI SE

(71) Anmelder: **Siemens Aktiengesellschaft**
**Wittelsbacherplatz 2**
**D-8000 München 2(DE)**

(72) Erfinder: **Herberg, Helmut, Dr. Dipl.-Phys.**
**Bruderhofstrasse 30a**
**D-8000 München 70(DE)**

(54) **Thyristor mit geringer Ansteuerleistung.**

(57) Thyristor mit einer Mehrzahl von Basisgebieten (4a, 4b) und in diese jeweils eingebetteten Emittergebieten (5a, 5b), bei dem jedem Basisgebiet (4a) ein erster Feldeffekttransistor (T1) zugeordnet ist, der bei Zuführung eines Zündspannungsimpulses (32) an seine Gateelektrode (13) einen Zündstromkreis für das in das Basisgebiet (4a) eingefügte Emittergebiet (5a) einschaltet, und bei dem in jedes Basisgebiet (4a) ein weiterer Feldeffekttransistor (T3) eingefügt ist, der bei Zuführung eines Löschspannungsimpulses (35) an seine Gateelektrode (23) einen Emitter-Basis-Kurzschluß zur Überbrückung des das eingebettete Emittergebiet (5a) begrenzenden pn-Übergangs wirksam schaltet.

EP 0 329 993 A2

## Thyristor mit geringer Ansteuerleistung

Die Erfindung bezieht sich auf einen Thyristor nach dem Oberbegriff des Patentanspruchs 1.

Ein Thyristor dieser Art ist aus der EP-A O 179 230 bekannt. Er weist mehrere Basisgebiete mit jeweils eingefügten Emittergebieten auf, wobei wenigstens einem dieser Basisgebiete ein Feldeffekttransistor zugeordnet ist, der aus einem in das Basisgebiet eingefügten Sourcegebiet, aus einer Randzone des Basisgebiets, aus einer die Randzone überdeckenden und durch eine dünne elektrisch isolierende Schicht von dieser getrennten Gateelektrode und aus einem an die Randzone angrenzenden Teilgebiet der an das Basisgebiet angrenzenden Thyristorbasis besteht, wobei das Sourcegebiet mit einer elektrisch leitenden Belegung versehen ist, die auch das Basisgebiet kontaktiert. Dieser Thyristor wird durch Zuführung eines Zündspannungsimpulses an die Gateelektrode, d.h. ohne nennenswerte Ansteuerleistung, gezündet.

Der Erfindung liegt die Aufgabe zugrunde, einen Thyristor der eingangs genannten Art anzugeben, der nicht nur mit einer sehr kleinen Ansteuerleistung gezündet, sondern auch mit einer vergleichbar kleinen Ansteuerleistung abgeschaltet werden kann. Das wird erfindungsgemäß durch eine Ausbildung nach dem kennzeichnenden Teil des Patentanspruchs 1 erreicht. Der mit der Erfindung erzielbare Vorteil liegt insbesondere darin, daß für die Zündung und für das Abschalten des Thyristors zwar zwei getrennte Steuereingänge notwendig sind, daß aber an diesen jeweils nur eine zum Umladen der Gateelektroden eines oder mehrerer Feldeffekttransistoren erforderliche Ansteuerleistung aufgebracht werden muß.

Der Patentanspruch 2 betrifft eine bevorzugte Weiterbildung der Erfindung, bei der sowohl für das Zünden als auch für das Ab schalten des Thyristors nur ein einziger Steuereingang benötigt wird, der mit den zur Umladung der Gateelektroden erforderlichen Ansteuerleistungen beaufschlagt werden muß. Der Patentanspruch 3 ist auf eine bevorzugte Ausgestaltung der Erfindung gerichtet.

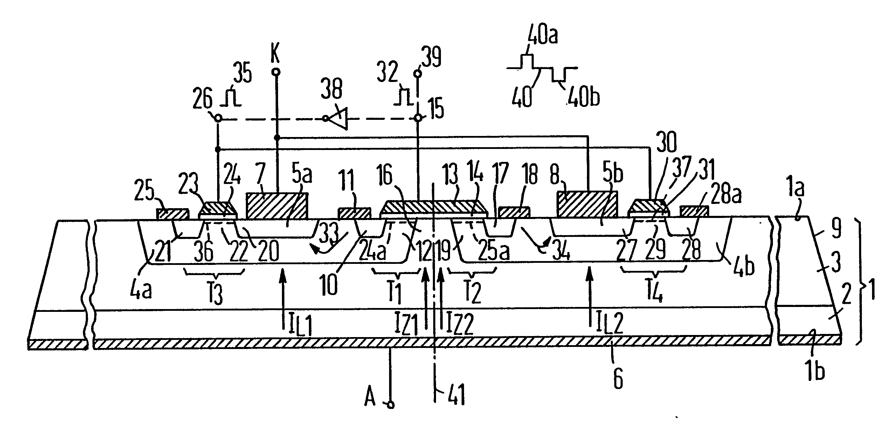

Die Erfindung wird nachfolgend anhand eines in der Zeichnung dargestellten, bevorzugten Ausführungsbeispiels näher erläutert.

Dabei wird von einem Thyristor mit einem scheibenförmigen Halbleiterkörper 1 aus dotiertem Halbleitermaterial, z.B. Silizium, ausgegangen. Er enthält eine Folge von Halbleiterschichten alternierender Leitfähigkeitstypen, die einen p-Emitter 2, eine n-Basis 3, eine p-Basis 4a, 4b und einen n-Emitter 5a, 5b darstellen. Der p-Emitter 2 ist dabei als eine zusammenhängende Schicht ausgebildet, die in einer Hauptfläche 1b von 1 mit einer an einen Anodenanschluß A gelegten anodenseitigen Elektrode 6 versehen ist. In der Hauptfläche 1b beträgt die Dotierungskonzentration des p-Emitters vorzugsweise etwa $10^{20}$cm$^{-3}$. Die n-Basis 3, die aus einer weiteren zusammenhängenden Schicht mit einer Dotierungskonzentration von etwa $10^{14}$cm$^{-3}$ besteht, erstreckt sich bis zu einer Hauptfläche 1a von 1. Die p-Basis des Thyristors besteht aus einer Mehrzahl von p-Basisgebieten, z.B. 4a und 4b, die in die n-Basis 3 so eingefügt sind, daß sie jeweils von der Hauptfläche 1a des Halbleiterkörpers 1 ausgehen. Der n-Emitter besteht schließlich aus einer Mehrzahl von n-Emittergebieten, z.B. 5a und 5b, die jeweils in die p-Basisgebiete, z.B. 4a und 4b, so eingefügt sind, daß sie ebenfalls von der Hauptfläche 1a ausgehen. Die n-Emittergebiete, z.B. 5a und 5b, die an der Hauptfläche 1a etwa eine Dotierungskonzentration von $10^{20}$cm$^{-3}$ aufweisen, sind in dieser Hauptfläche jeweils mit Teilen 7, 8 einer kathodenseitigen Elektrode versehen, die mit einem Kathodenanschluß K verbunden sind. Die Dotierungskonzentration der p-Basisgebiete, z.B. 4a, beträgt dort, wo sie an die eingefügten n-Emittergebiete, z.B. 5a, angrenzen, z.B. $10^{17}$cm$^{-3}$.

Auch in den sich nach links und rechts anschließenden, nicht dargestellten Teilen des Halbleiterkörpers 1 sind weitere Basisgebiete vorgesehen, in die ebenfalls n-Emittergebiete eingefügt sind, wobei letztere wieder von Teilen der kathodenseitigen Elektrode kontaktiert werden, die mit K verbunden sind. Der abgeschrägte Rand des Thyristors ist mit 9 bezeichnet.

In das p-Basisgebiet 4a ist das n-leitende Sourcegebiet 10 eines n-Kanal-Feldeffekttransistors T1 eingefügt, das sich bis zur Hauptfläche 1a erstreckt und in dieser mit einer leitenden Belegung 11 versehen ist, die in Richtung auf das n-Emittergebiet 5a soweit verlängert ist, daß sie die laterale Begrenzung von 10 überragt und das p-Basisgebiet 4a kontaktiert. Eine Randzone 12 des p-Basisgebiets 4a, die sich bis an die Hauptfläche 1a und bis an den rechten Rand des Sourcegebietes 10 erstreckt, wird von einer Gateelektrode 13 überdeckt, die durch eine dünne elektrisch isolierende Schicht 14 von der Hauptfläche 1a getrennt ist und mit einem Steuereingang 15 verbunden ist. Der an die Randzone 12 rechtsseitig angrenzende Teilbereich 16 der n-Basis 3 bildet das Draingebiet von T1. Analog hierzu ist in das p-Basisgebiet 4b das n-leitende Sourcegebiet 17 eines n-Kanal-Feldeffekttransistors T2 eingefügt, das mit einer leitenden Belegung 18 versehen ist, die das p-Basisgebiet 4b kontaktiert. Zu T2 gehört weiterhin die Randzone 19 des Basisgebiets 4b, die ebenfalls von der Gateelektrode 13 überdeckt wird. Das Draingebiet von T2 wird von dem Teilbereich 16 der n-Basis 3 gebildet. Die Ansteuerung von T2 erfolgt gemeinsam mit der von T1 über den Steuereingang 15.

In das p-Basisgebiet 4a ist ein n-Kanal-Feldeffekttransistor T3 eingefügt, der aus der linken Randzone 20 des n-Emittergebiets 5a, aus einer in das p-Basisgebiet 4a eingebetteten, n-leitenden Halbleiterzone 21 und aus einem zwischen den Zonen 20 und 21 liegenden Teilgebiet 22 des p-Basisgebiets 4a besteht. Dabei wird das Teilgebiet 22 von einer Gateelektrode 23 überdeckt, die von der Hauptfläche 1a durch eine elektrisch isolierende Schicht 24 getrennt ist. Außerdem wird die Halbleiterzone 21 von einer elektrisch leitenden Belegung 25 kontaktiert, die auch das p-Basisgebiet 4a kontaktiert. Die Gateelektrode 23 ist mit einem Steuereingang 26 verbunden. In entsprechender Weise ist ein weiterer n-Kanal-Feldeffekttransistor T4 in das p-Basisgebiet 4b eingefügt, der aus der rechten Randzone 27 des n-Emittergebiets 5b, aus einer in das p-Basisgebiet 4b eingebetteten, n-leitenden Halbleiterzone 28 und aus einem zwischen den Zonen 27 und 28 liegenden Teilgebiet 29 des p-Basisgebiets 4b besteht. Das Teilgebiet 29 wird von einer Gateelektrode 30 überdeckt, die durch eine elektrisch isolierende Schicht 31 von der Hauptfläche 1a getrennt ist. Eine elektrisch leitende Belegung 28a kontaktiert die Halbleiterzone 28 und das p-Basisgebiet 4b. Die Gateelektrode 30 ist mit dem Steuereingang 26 verbunden, über den die Feldeffekttransistoren T3 und T4 gemeinsam angesteuert werden.

Im blockierenden Zustand des Thyristors liegt z.B. eine Spannung von 1000 Volt zwischen den Anschlüssen A und K, wobei der Anschluß A ein positiveres Potential aufweist als K. Legt man nun einen positiven Zündspannungsimpuls 32 bei 15 an, so bilden sich in den Randzonen 12 und 19 unterhalb der Gateelektrode 13 Inversionsschichten 24a und 25a aus, die leitende Kanäle zwischen dem Sourcegebiet 10 und dem Draingebiet 16 sowie zwischen dem Sourcegebiet 17 und dem Draingebiet 16 darstellen. Über den Kanal 24a fließt dann ein Zündstrom $I_{z1}$ von der anodenseitigen Elektrode 6 zum Sourcegebiet 10 und von diesem über die leitende Belegung 11 in Richtung des Pfeils 33 zum pn-Übergang zwischen den Teilen 4a und 5a. Das n-Emittergebiet 5a injiziert daraufhin negative Ladungsträger in das p-Basisgebiet 4a, die in Richtung auf den p-Emitter 2 transportiert werden und am pn-Übergang zwischen den Teilen 2 und 3 eine Injektion von positiven Ladungsträgern in die n-Basis 3 bewirken. Damit zündet der Thyristor im Bereich des n-Emittergebiets 5a. Hieraus resultiert ein Laststromanteil $I_{L1}$, der bei einem zwischen den Anschlüssen A und K liegenden äußeren Stromkreis zwischen den Elektroden 6 und 7 fließt. In analoger Weise wird durch den Zündspannungsimpuls 32 ein Zündstrom $I_{z2}$ hervorgerufen, der dem pn-Übergang zwischen den Teilen 4b und 5b über den leitend geschalteten Transistor T2 längs des Pfeils 34 zugeführt wird. Hieraus resultiert ein Laststromanteil $I_{L2}$, der zwischen den Elektroden 6 und 8 fließt. Die genannten Laststromanteile setzen sich mit entsprechenden Laststromanteilen im Bereich weiterer p-Basisgebiete mit eingeschlossenen n-Emittergebieten zu einem Laststrom $I_L$ des Thyristors zusammen.

Zum Abschalten des Thyristors wird dem Steuereingang 26 ein positiver Löschspannungsimpuls 35 zugeführt. Dieser bewirkt die Bildung einer Inversionsschicht 36 unterhalb der Gateelektrode 23 im Teilgebiet 22 sowie einer entsprechenden Inversionsschicht 37 unterhalb der Gateelektrode 30 im Teilgebiet 29. Diese Inversionsschichten stellen leitende Kanäle dar, die das Sourcegebiet 21 niederohmig mit dem n-Emittergebiet 5a und das Sourcegebiet 28 niederohmig mit dem n-Emittergebiet 5b verbinden. Über die leitende Belegung 25 und den Kanal 36 wird der pn-Übergang zwischen den Teilen 5a und 4a kurzgeschlossen, über die leitende Belegung 28a und den Kanal 37 der pn-Übergang zwischen den Teilen 5b und 4b. Hierdurch werden die aus dem p-Emitter 2 in die n-Basis 3 injizierten positiven Ladungsträger, die ohne diese Kurzschlüsse zu den Grenzflächen zwischen den Teilen 4a und 5a sowie zwischen 4b und 5b transportiert werden würden, im wesentlichen über die Sourcegebiete 21 bzw. 28 und die leitenden Kanäle 36 bzw. 37 in die n-Emittergebiete 5a und 5b transportiert, ohne daß sie an den pn-Übergängen der n-Emittergebiete 5a und 5b weitere Injektionsvorgänge auslösen können. Damit werden aber die Laststromanteile $I_{L1}$ und $I_{L2}$ und die in den Bereichen weiterer p-Basisgebiete auftretenden, weiteren Laststromanteile abgeschaltet, so daß der Thyristor gelöscht wird.

Zum Zünden des Thyristors genügt es, die Kapazitäten der Gateelektrode 13 und weiterer dieser parallel geschalteter Gateelektroden gegenüber dem Halbleiterkörper auf den Spannungswert des Zündspannungsimpulses 32 aufzuladen, während es zum Löschen ausreicht, die Kapazitäten der Gateelektroden 23 und 30 sowie weiterer, diesen parallel geschalteter Gateelektroden auf den Spannungswert des Löschspannungsimpulses 35 aufzuladen. Beides kann ohne nennenswerten Leistungsverbrauch geschehen.

Nach einer bevorzugten Weiterbildung wird der Steuereingang 15 mit dem Eingang eines Inverters 38 und mit einem gemeinsamen Steuereingang 39 verbunden, während der Ausgang des Inverters 38 mit dem Steuereingang 26 beschaltet wird. Damit kann dem gemeinsamen Steuereingang 39 eine Impulsspannung 40 zugeführt werden, die sich aus einer Folge von positiven und negativen Impulsen 40a und 40b zusammensetzt. Jeder positive Impuls 40a bewirkt hier entsprechend dem Impuls 32 die Zündung des Thyristors, während jeder negative Impuls 40b entsprechend dem Impuls 35 zur Löschung des Thyristors führt. Eine Entkopplung der Steuereingänge 15 und 26 erfolgt durch die Funktion des Inverters 38, der vorzugsweise auf dem Thyristor integriert wird.

In Abweichung von der dargestellten Ausführungsform der Erfindung kann die die Randzonen 12 und 19 gemeinsam überdeckende Gateelektrode 13 auch durch zwei getrennte, jeweils mit dem Steuereingang 15 verbundene Gateelektroden ersetzt sein. Nach einer ersten Ausgestaltung der dargestellten Ausführungsform sind die Gebiete 4a, 4b und 5a, 5b sowie die Teile 7, 8, 10, 13, 17, 21, 23, 28 und 30 streifenförmig ausgebildet, wobei ihre Abmessungen in einer etwa senkrecht zur Bildebene verlaufenden Richtung größer sind als in der Bildebene. Andererseits kann die Querschnittsdarstellung beispielsweise auch so aufgefaßt werden, daß es sich um einen rotationssymemtrischen Halbleiterkörper mit einer Symmetrieachse 41 handelt. Dabei sind die Gebiete 4a und 5a kreisringförmig ausgebildet, wobei dann mit 4b und 5b lediglich weitere Querschnitte der bereits durch 4a und 5a dargestellten, kreisringförmigen Gebiete bezeichnet sind. Entsprechendes gilt dann auch für die dargestellten Elektroden und die Gebiete 10 und 21, die ebenfalls kreisringförmig ausgebildet sind.

Neben den bisher beschriebenen Ausführungsformen gehören auch solche zur Erfindung, bei denen die genannten Halbleitergebiete jeweils durch solche des entgegengesetzten Leitfähigkeitstyps ersetzt sind, wobei anstelle der genannten Spannungen und Ströme solche des entgegengesetzten Vorzeichens verwendet werden. In diesen Fällen sind auch die Bezeichnungen der Anschlüsse A und K miteinander zu vertauschen.

**Ansprüche**

1. Thyristor mit einer Folge von Halbleiterschichten alternierender Leitfähigkeitstypen, die einen mit einer anodenseitigen Elektrode (6) versehenen p-Emitter (2), eine n-Basis (3), eine p-Basis (4a, 4b) und einen mit einer kathodenseitigen Elektrode (7, 8) versehenen n-Emitter (5a, 5b) darstellen, bei dem einer der Emitter aus einem oder mehreren Emittergebieten (5a, 5b) besteht, bei dem die an diesen Emitter angrenzende Basis aus einem oder mehreren Basisgebieten (4a, 4b) besteht, die jeweils ein Emittergebiet (5a, 5b) enthalten, und bei dem wenigstens einem der Basisgebiete (4a) ein erster Feldeffekttransistor (T1) zugeordnet ist, der aus einem in das Basisgebiet (4a) eingefügten und zu diesem entgegengesetzt dotierten Sourcegebiet (10), aus einer Randzone (12) des Basisgebiets, aus einer die Randzone (12) überdeckenden, durch eine dünne elektrisch isolierende Schicht (14) von dieser getrennten ersten Gateelektrode (13) und aus einem an die Randzone (12) angrenzenden Teilgebiet (16) der an das Basisgebiet (4a) angrenzenden Basis (3) als Draingebiet besteht, wobei das Sourcegebiet (10) mit einer ersten elektrisch leitenden Belegung (11) versehen ist, die auch das Basisgebiet (4a) kontaktiert, und wobei alle ersten Gateelektroden (13) mit einem ersten Steuereingang (15) verbunden sind, **dadurch gekennzeichnet,** daß in wenigstens ein Basisgebiet (4a) ein zweiter Feldeffekttransistor (T3) eingefügt ist, der aus einer Randzone (20) des in dem Basisgebiets enthaltenen Emittergebiets (5a), aus einer den gleichen Leitfähigkeitstyp aufweisenden, in das Basisgebiet eingefügten Halbleiterzone (21) und aus einem zwischen der Randzone (20) des Emittergebiets und der Halbleiterzone (21) liegenden Teilgebiet (22) des Basisgebiets besteht, das von einer gegen dieses Teilgebiet (22) elektrisch isolierten zweiten Gateelektrode (23) überdeckt wird, daß die Halbleiterzone (21) von einer zweiten elektrisch leitenden Belegung (25) kontaktiert wird, die auch das Basisgebiet (4a) kontaktiert, und daß alle zweiten Gateelektroden (23) mit einem zweiten Steuereingang (26) verbunden sind.

2. Thyristor nach Anspruch 1, **dadurch gekennzeichnet,** daß der eine der beiden Steuereingänge (15) mit einem gemeinsamen Steuereingang (39) und mit dem Eingang eines Inverters (38) verbunden ist, dessen Ausgang mit dem anderen Steuereingang (26) in Verbindung steht.

3. Thyristor nach Anspruch 1 oder 2, **dadurch gekennzeichnet,** daß die ersten Gateelektroden von zwei benachbarten Basisgebieten (4a, 4b) zugeordneten, ersten Feldeffekttransistoren (T1, T2) durch eine gemeinsame, die einander zugewandten Randzonen (12, 19) beider Basisgebiete (4a, 4b) überdeckende Gateelektrode (13) gebildet werden.